# EUROPEAN PATENT APPLICATION

(11) **EP 2 343 801 A2**
(43) Date of publication of application: **13.07.2011**
(21) Application number: 10195276.0
(22) Date of filing: 15.12.2010
(51) Int. Cl.: H03G 3/34

(54) **Audio apparatus**

(30) Priority: 30.12.2009 CN 200910312739
(71) Applicant: Hong Fu Jin Precision Industry (ShenZhen) Co., Ltd., Longhua Town, Bao'an District Shenzhen City Guangdong 518109 (CN); Hon Hai Precision Industry Co., Ltd., Tu-cheng City, Taipei Hsien (TW)
(72) Inventor: Wang, Tao, 518109 Shenzhen Guangdong (CN)
(74) Representative: Gray, John James

(57) **Abstract**

An audio apparatus (100) receives a supply voltage from a power source (200) and is powered on. The audio apparatus (100) includes a control unit (20), an amplifier (30), and a mute circuit (10). The control unit (20) provides an audio signal. The amplifier (30) amplifies the audio signal and drives a speaker (300) to reproduce sound according to the amplified audio signal. The mute circuit (10) generates a mute signal when initially receiving the supply voltage from the power source (200). The amplifier (30) stops driving the speaker (300) to reproduce sound according to the mute signal.

## Description

### 1. Field of the Disclosure

The present disclosure relates to audio apparatuses, and more particularly to an audio apparatus with a mute circuit.

### 2. Description of Related Art

An audio apparatus, such as a portable DVD player, a television, etc., includes speakers. The audio apparatus is powered on when a supply voltage from a power source is provided, thus the speakers can reproduce sound. The audio apparatus is powered off when the power source stops providing the supply voltage, thus the speakers stop working.

However, when the audio apparatus is powered on or off, a surge in voltage may occur, thus the speaker outputs loud pop noise, this surge noise can damage speakers and can be uncomfortable for users.

Therefore, there is room for improvement in the art.

### SUMMARY

According to an exemplary embodiment of the invention, an audio apparatus receives a supply voltage from a power source and is powered on. The audio apparatus includes a control unit, an amplifier, and a mute circuit. The control unit provides an audio signal. The amplifier amplifies the audio signal and drives a speaker to reproduce sound according to the amplified audio signal. The mute circuit generates a mute signal when initially receiving the supply voltage from the power source. The control unit further generates a trigger signal when not receiving the supply voltage from the power source, and the mute circuit generates the mute signal according to the trigger signal. The amplifier stops driving the speaker to reproduce sound according to the mute signal. Therefore, noise generated by the speaker when the audio apparatus is powered on or off is eliminated.

### BRIEF DESCRIPTION OF THE DRAWINGS

The components of the drawings are not necessarily drawn to scale, the emphasis instead being placed upon clearly illustrating the principles of the embodiments of an electronic device. Moreover, in the drawings, like reference numerals designate corresponding parts throughout two views.

FIG. 1 is a block diagram of an audio apparatus in accordance with an exemplary embodiment.

FIG. 2 is a circuit diagram of the audio apparatus of FIG. 1 with an exemplary embodiment.

### DETAILED DESCRIPTION

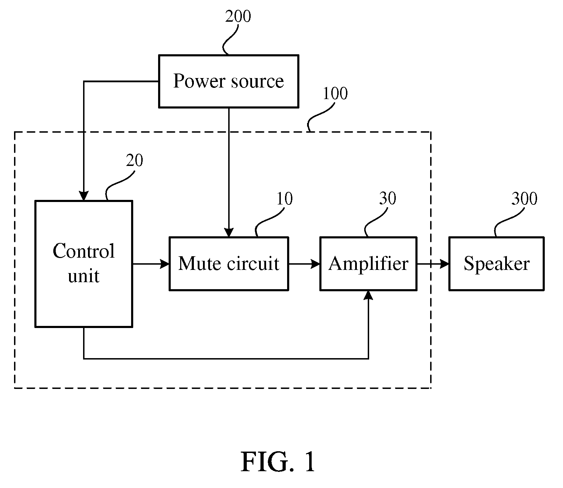

Referring to FIG. 1, an audio apparatus 100 connects a power source 200 with a speaker 300. The audio apparatus 100 includes a mute circuit 10, a control unit 20, and an amplifier 30. The mute circuit 10 and the control unit 20 receive a supply voltage from the power source 200. The control unit 20 is used for providing an audio signal to the amplifier 30. The amplifier 30 is used for amplifying the audio signal and providing the amplified audio signal to the speaker 300 for reproducing sound.

The mute circuit 10 is used for generating a mute signal when initially receiving the supply voltage from the power source 200. The amplifier 30 stops driving the speaker 300 to reproduce sound in response to the mute signal, thus noise generated by the speaker 300 when the audio apparatus 100 is powered on is eliminated. In this embodiment, the power source 200 includes a power supply and a capacitor, when the power supply provides the supply voltage to the mute circuit 10 and the control unit 20, the supply voltage charges up the capacitor. When the power supply stops providing the supply voltage, the capacitor discharges, thus the mute circuit 10 and the control unit 20 are powered, momentarily, by the capacitor.

The control unit 20 is used for generating a trigger signal when not receiving the supply voltage from the power source 200. The mute circuit 10 generates the mute signal to the amplifier 30 according to the trigger signal, and the amplifier 30 stops driving the speaker 300 to reproduce sound in response to the mute signal, thus noise generated by the speaker 300 when the audio apparatus 100 is powered off is eliminated.

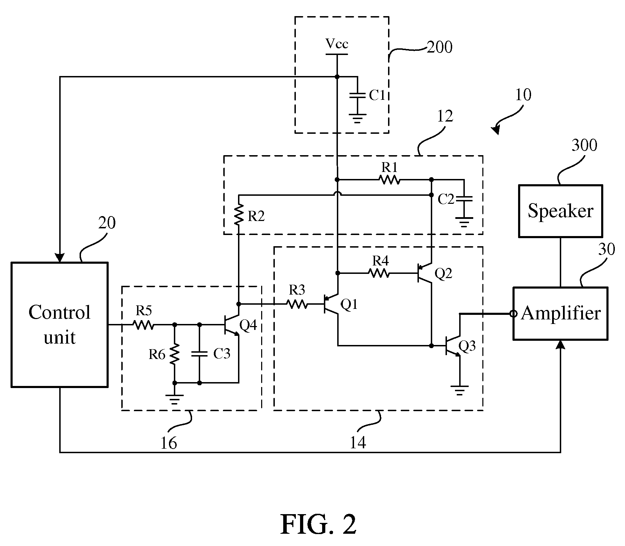

Referring to FIG. 2, the power source 200 includes a power supply Vcc for providing the supply voltage and a first capacitor C1. One end of the first capacitor C1 is connected to the power supply Vcc, and the other end of the first capacitor C1 is grounded. The power supply Vcc couples the mute circuit 10 and the control unit 20.

The mute circuit 10 includes a first unit 12, a signal generating unit 14, and a second unit 16. The first unit 12 is used for generating a first level signal when receiving the supply voltage from the power source 200, the signal generating unit 14 receives the first level signal and the supply voltage to generate the mute signal. Thus, the amplifier 30 stops driving the speaker 300 to reproduce sound according to the mute signal.

The first unit 12 further generates a second level signal when having received the supply voltage from the power source 200 for a predetermined time period, the signal generating unit 14 receives the second level signal and the supply voltage to stop generating the mute signal. Thus the amplifier 30 drives the speaker to reproduce sound. In this embodiment, the first level signal is a low level voltage signal, the second level signal is a high level voltage signal.

The second unit 16 receives the trigger signal from the control unit 20 to generate the first level signal, the signal generating unit 14 receives the first level signal from the second unit 16 and the supply voltage from the power source 200 to generate the mute signal.

The first unit 12 includes a first resistor R1, a second resistor R2, and a second capacitor C2. One end of the first resistor R1 is connected to the power supply Vcc, and the other end of the first resistor R1 is grounded through the second capacitor C2. One end of the second resistor R2 is connected between the first resistor R1 and the second capacitor C2, and the other end of the second resistor R2 is connected to the signal generating unit 14 and the second unit 16.

The signal generating unit 14 includes a third resistor R3, a fourth resistor R4, a first transistor Q1, a second transistor Q2, and a third transistor Q3. A base of the first transistor Q1 is connected to the second resistor R2 and the second unit 16 through the third resistor R3, an emitter of the first transistor Q1 is connected to the power source 200, a collector of the first transistor Q1 is connected to the collector of the second transistor Q2 and the base of the third transistor Q3. The base of the second transistor Q2 is connected to the power source 200 through the fourth resistor R4, the emitter of the second transistor Q2 is connected between the first resistor R1 and the first capacitor C1, the collector of the third transistor Q3 is connected to the amplifier 30, the emitter of the third transistor Q3 is grounded.

The second unit 16 includes a fifth resistor R5, a sixth resistor R6, a third capacitor C3, and a fourth transistor Q4. The base of the fourth transistor Q4 is connected to the control unit 20 through the fifth resistor R5, the collector of the fourth transistor Q4 is connected to the second resistor R2 and the third resistor R3, the emitter of the fourth transistor Q4 is grounded. The sixth resistor R6 and the third capacitor C3 are connected between the base of the fourth transistor Q4 and ground in parallel. In this embodiment, the first transistor Q1 and the second transistor Q2 are PNP type transistor, the third transistor Q3 and the fourth transistor Q4 are NPN type transistor.

The principal of the audio apparatus 100 is illustrated as follows:

When the audio apparatus 100 is powered on, the power supply Vcc starts to provide the supply voltage to the first unit 12, the voltage across the second capacitor C2 is zero volts, the first transistor Q1 turns on, and the third transistor Q3 also turns on. The amplifier 30 receives a low level voltage signal, thus amplifier 30 stops driving the speaker 300 to reproduce sound.

The supply voltage from the power supply Vcc charges up the second capacitor C2 through the first resistor R1 and the first capacitor C1, after a predetermined time period, the voltage across the second capacitor C2 is equal to the supply voltage. The first transistor Q1 is cut off, the third transistor Q3 is also cut off. The amplifier 30 cannot receive the low level voltage signal and drives the speaker 300 to reproduce sound.

When the audio apparatus 100 is powered off, the power supply Vcc stops providing the supply voltage, the first capacitor C1 and the second capacitor C2 discharges, the control unit 20 receives the discharge voltage from the first capacitor C1 and generates a high level voltage signal. The base of the fourth transistor Q4 receives the high level voltage signal through the fifth resistor R5, and the fourth transistor Q4 is turned on. The base of the first transistor Q1 is pulled low, the emitter of the first transistor Q1 is pulled high by the discharge voltage of the second capacitor C2, and the first transistor Q1 is turned on. The base of the third capacitor Q3 is pulled high by the discharge voltage of the second capacitor C2, and the third capacitor Q3 is turned on. The amplifier 30 receives a low level voltage signal, thus amplifier 30 stops driving the speaker 300 to reproduce sound. Therefore, noise generated by the speaker 300 is eliminated when the audio apparatus 100 is powered on or off.

Further alternative embodiments will become apparent to those skilled in the art without departing from the spirit and scope of what is claimed. Accordingly, the present invention should be deemed not to be limited to the above detailed description, but rather only by the claims that follow and equivalents thereof.

## Claims

1. An audio apparatus receiving a supply voltage from a power source and then being powered on, the audio apparatus comprising:
a control unit for providing an audio signal;
an amplifier for amplifying the audio signal and driving a speaker to reproduce sound according to the amplified audio signal; and
a mute circuit for generating a mute signal when initially receiving the supply voltage from the power source;
wherein the amplifier stops driving the speaker to reproduce sound according to the mute signal.

2. The audio apparatus of claim 1, wherein the power source comprises a power supply for providing the supply voltage and a first capacitor is charged up by the supply voltage, when the power supply stops providing the supply voltage, the first capacitor discharges, the control unit receives a discharge voltage from the first capacitor and generates a trigger signal, the mute circuit generates the mute signal according to the trigger signal.

3. The audio apparatus of claim 2, wherein the mute circuit comprises a first unit and a signal generating unit connected to the power supply, the first unit generates a first level signal when initially receiving the supply voltage, the signal generating unit receives the first level signal and the supply voltage, and generates the mute signal.

4. The audio apparatus of claim 3, wherein the mute circuit further comprises a second unit, the second unit receives the trigger signal, generates the first level signal, and sends the first level signal to the signal generating unit.

5. The audio apparatus of claim 3 or 4, wherein the first unit generates a second level signal when having received the supply voltage for a predetermined time period, the signal generating unit receives the second level signal and the supply voltage, and stops generating the mute signal.

6. The audio apparatus of claim 5, wherein the first level signal is a low level voltage signal, the second level signal is a high level voltage signal.

7. The audio apparatus of claim 4, 5 or 6, wherein one end of the first capacitor is connected to the power supply, the other end of the first capacitor is grounded, the first unit comprises a first resistor, a second resistor, and a second capacitor, one end of the first resistor is connected to the power supply, the other end of the first resistor is grounded through the second capacitor, one end of the second resistor is connected between the first resistor and the first capacitor, the other end of the second resistor is connected to the second unit and the signal generating unit.

8. The audio apparatus of claim 7, wherein the signal generating unit comprises a third resistor, a fourth resistor, a first transistor, a second transistor, and a third transistor, a base of the first transistor is connected to the second resistor and the second unit through the third resistor, an emitter of the first transistor is connected to the power supply, a collector of the first transistor is connected to the collector of the second transistor and the base of the third transistor, the base of the second transistor is connected to the power supply through the fourth resistor, the emitter of the second transistor is connected between the first resistor and the first capacitor, the collector of the third transistor is connected to the amplifier, the emitter of the third transistor is grounded.

9. The audio apparatus of claim 8, wherein the second unit comprises a fifth resistor, a sixth resistor, a second capacitor, and a fourth transistor, the base of the fourth transistor is connected to the control unit through the fifth resistor, the collector of the fourth transistor is connected to the second resistor and the third resistor, the emitter of the fourth transistor is grounded, the sixth resistor and the second capacitor are connected between the base of the fourth transistor and ground in parallel.

10. An audio apparatus receiving a supply voltage from a power source and then being powered on, the audio apparatus comprising:
a control unit for providing an audio signal;
an amplifier for amplifying the audio signal and driving a speaker to reproduce sound according to the amplified audio signal; and
a mute circuit;
wherein the power source comprises a power supply for providing the supply voltage and a first capacitor is charged up by the supply voltage, the control unit receives a discharge voltage from the first capacitor and generates a trigger signal when the power supply stops providing the supply voltage, the mute circuit generates a mute signal according to the trigger signal, the amplifier stops driving the speaker to reproduce sound according to the mute signal.

11. The audio apparatus of claim 10, wherein the mute circuit generates the mute signal when initially receiving the supply voltage from the power supply.

12. The audio apparatus of claim 11, wherein the mute circuit comprises a first unit and a signal generating unit connected to the power supply, the first unit generates a first level signal when initially receiving the supply voltage, the signal generating unit receives the first level signal and the supply voltage, and generates the mute signal.

13. The audio apparatus of claim 12, wherein the mute circuit further comprises a second unit, the second unit receives the trigger signal, generates the first level signal, and sends the first level signal to the signal generating unit.

14. The audio apparatus of claim 12 or 13, wherein the first unit generates a second level signal when having received the supply voltage for a predetermined time period, the signal generating unit receives the second level signal and the supply voltage, and stops generating the mute signal.

15. The audio apparatus of claim 13 or 14, wherein one end of the first capacitor is connected to the power supply, the other end of the first capacitor is grounded, the first unit comprises a first resistor, a second resistor, and a second capacitor, one end of the first resistor is connected to the power supply, the other end of the first resistor is grounded through the second capacitor, one end of the second resistor is connected between the first resistor and the first capacitor, the other end of the second resistor is connected to the second unit and the signal generating unit.
